# EUROPÄISCHE PATENTSCHRIFT

(11) **EP 2 293 439 B1**
(45) Veröffentlichungstag und Bekanntmachung des Hinweises auf die Patenterteilung: **23.10.2013**
(21) Anmeldenummer: 10182723.6
(22) Anmeldetag: 22.06.2006
(51) Int. Cl.: H03H 9/02, H03H 9/60

(54) **BAW-Filter mit Leiterstruktur mit BAW-Vorrichtung sowohl als Parallel- als auch als Serienelement**
BAW ladder filter with BAW apparatus as parallel and as series element
Filtre BAW en échelle avec dispositf BAW employé comme élément parallèle et comme élément série

(30) Priorität: 22.06.2005 DE 102005028927
(43) Veröffentlichungstag der Anmeldung: 09.03.2011
(62) Teilanmeldung aus: 06012858.4
(73) Patentinhaber: Avago Technologies Wireless IP (Singapore) Pte. Ltd., Singapore 768923 (SG)
(72) Erfinder: Aigner, Robert, Ocoee, FL 34761 (US); Handtmann, Martin, 81737 München (DE)
(74) Vertreter: Dilg, Haeusler, Schindelmann Patentanwaltsgesellschaft mbH

(56) Entgegenhaltungen:
- JP-A- 60 150 310
- US-A- 5 294 862
- US-A1- 2003 128 081
- RUBY R ET AL: "PCS 1900 MHz duplexer using thin film bulk acoustic resonators (FBARs)", IEE ELECTRONICS LETTERS, Bd. 35, Nr. 10, 13. Mai 1999 (1999-05-13), Seiten 794-795, XP006012145,

## Beschreibung

Die vorliegende Erfindung bezieht sich auf ein BAW-Filter mit Leiterstruktur (BAW=Bulk Acoustic Wave), das eine erste BAW-Vorrichtung als Serienelement und eine zweite BAW-Vorrichtung als Parallelelement enthält.

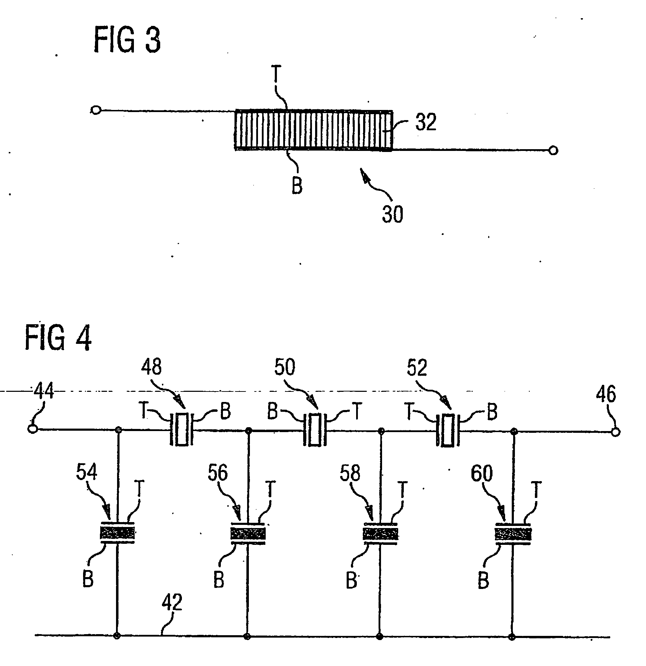

BAW-Resonatoren finden aufgrund ihrer hohen Resonanzfrequenz und ihrer hohen Güte insbesondere im Mobilfunk weite Verbreitung. Die einfachste Ausführung eines BAW-Resonators weist eine dünne Schicht aus piezoelektrischem Material auf, das zwischen zwei Metallelektroden angeordnet ist. Übliche piezoelektrische Materialien sind beispielsweise Aluminiumnitrid (A1N) oder Zinkoxid (Zn0) . Fig. 3 zeigt einen beispielhaften BAW-Resonator 30 mit einer statischen Kapazität C, der eine Schicht aus piezoelektrischem Material aufweist, die im weiteren als Piezo-Schicht 32 bezeichnet wird und zwischen einer ersten Elektrode bzw. einer Top-Elektrode T, und einer zweiten Elektrode bzw. einer Bottom-Elektrode B angeordnet ist. Wobei die Bezeichnung Top-Elektrode bzw. Bottom-Elektrode lediglich Defintionszwecken dient und keine Einschränkung bezüglich der räumlichen Anordnung und Positionierung des BAW-Resonators bedeutet. Die Bezeichnung Top-Elektrode bzw. Bottom-Elektrode dient vielmehr der Definition der Lage dieser Elektroden relativ zu einer Polarisierung des piezoelektrischen Materials, wie es im folgenden noch erläutert wird, so dass aus einem Ersatzschaltbild, das die T- und B-Elektroden nennt, die Polarisation der jeweiligen BAW-Resonatoren hervorgeht.

Wird ein elektrisches Feld zwischen der ersten Elektrode T und der zweiten Elektrode B des BAW-Resonators 30 angelegt, so expandiert oder kontrahiert der BAW-Resonator 30 mechanisch aufgrund des reziproken bzw. inversen piezoelektrischen Effektes, wobei der Fall Expansion oder Kontraktion, wie oben erwähnt, von der Polarisation des piezoelektrischen Materials abhängt. Das bedeutet, wird das elektrische Feld umgekehrt zwischen T- und B-Elektrode angelegt, tritt der umgekehrte Fall ein. Im Fall eines Wechselfeldes wird in der Piezo-Schicht 32 eine akustische Welle erzeugt, die sich je nach Ausführung des BAW-Resonators beispielsweise als Longitudinalwelle parallel zu dem elektrischen Feld oder als Transversalwelle quer zu dem elektrischen Feld ausbreitet und beispielsweise an der Grenzfläche der Piezo-Schicht 32 reflektiert wird. Dabei treten immer dann Resonanzzustände bzw. akustische Resonanzschwingungen auf, wenn die Dicke d der Piezo-Schicht 32 gleich einem ganzzahligen Vielfachen der halben Wellenlänge λ der akustischen Wellen ist. Die Grundresonanzfrequenz, also die kleinste Resonanzfrequenz fᵣₑₛ, ist dann umgekehrt proportional zu der Dicke d der Piezo-Schicht 32. Daß heißt, der BAW-Resonator schwingt mit der von extern vorgegebenen Frequenz.

Die piezoelektrischen Eigenschaften und damit auch die Re-"sonanzeigenschaften eines BAW-Resonators hängen von verschiedenen Faktoren ab, z.B. von dem piezoelektrischen Material, dem Herstellungsverfahren und der dem BAW-Resonator bei der Herstellung eingeprägten Polarisation und der Größe der Kristalline ab. Insbesondere die Resonanzfrequenz aber hängt, wie erwähnt, von der Dicke d der Piezo-Schicht ab.

Wie oben erwähnt, weisen BAW-Resonatoren eine elektrische Polarisation auf. Dabei hängt die Richtung der mechanischen Verformung, Extraktion oder Kontraktion, des BAW-Resonators von der Richtung des an der ersten- Elektrode T und der zweiten Elektrode B angelegten elektrischen Feldes und der Richtung der Polarisation des BAW-Resonators 30 ab. Sind die Polarisation des BAW-Resonators und die Richtung des elektrischen Feldes gleich gerichtet, kontrahiert der BAW-Resonator 30 beispielsweise, während wenn die Polarisation des BAW-Resonators 30 und die Richtung des elektrischen Feldes entgegengesetzt gerichtet sind, der BAW-Resonator 30 expandiert.

BAW-Resonatoren sind in verschiedensten Konfigurationen bekannt. Typischerweise unterscheidet man sogenannte FBAR (FBAR = Film Bulk Acoustic Resonator) und SMR (SMR = Solidly Mounted Resonator). Darüber hinaus sind nicht nur BAW-Resonatoren mit einer Piezo-Schicht 32 sondern auch BAW-Resonatoren mit mehreren Piezo-Schichten bekannt.

BAW-Resonatoren werden beispielsweise für Filter eingesetzt. Fig. 4 zeigt ein Schaltbild eines möglichen BAW-Filters in Leiter-Struktur, der eine elektrische Masse 42, einen Signaleingang 44, einen Signalausgang 46, einen ersten Serienresonator 48, einen zweiten Serienresonator 50, einen dritten Serienresonator 52, einen ersten Parallelresonator 54, einen zweiten Parallelresonator 56, einen dritten Parallelresonator 58 und einen vierten Parallelresonator 60 aufweist, wobei die Serienresonatoren 48, 50, 52 in Serie zwischen den Signaleingang 44 und den Signalausgang 46 geschaltet sind und der erste Parallelresonator 54 parallel zwischen den Signaleingang 44 und die elektrische Masse 42, der zweite Parallelresonator zwischen einen Verbindungsknoten zwischen dem ersten Serienresonator 48 und dem zweiten Serienresonator 50 sowie die elektrische Masse 42, der dritte Parallelresonator 58 zwischen einen Verbindungsknoten zwischen den zweiten Serienresonator 50 und den dritten Serienresonator 52 sowie die elektrische Masse und der vierte Parallelresonator 60 parallel zwischen den Signalausgang 46 und die elektrische Masse 42 geschaltet ist. Die Serienresonatoren werden im Englischen auch als "series resonators" bezeichnet und die Parallelresonatoren als "shunt resonators". Jeder der Serien- und Parallelresonatoren weist eine Top-Elektrode T und Bottom-Elektrode B auf, die in dem Ersatzschaltbild von Fig. 4 angezeigt sind, um die Polarisation der BAW-Resonatoxen anzuzeigen.

Ein Problem bei beispielsweise Filterschaltungen ist die thermische Belastung der BAW-Resonatoren. Dieses Problem kann jedoch beispielsweise durch die Methode des "Kaskadierens" von BAW-Resonatoren gelöst werden, und wird bei BAW-Bauelementen viel genutzt. Unter Kaskade soll im folgenden eine Kette bzw. Serienschaltung von Schaltelementen verstanden werden. Ein BAW-Resonator mit der statischen Kapazität C wird durch eine Kaskade von zwei BAW-Resonatoren ersetzt, die jeweils eine statische Kapazität von 2C haben, so dass die Gesamtkapazität wieder C beträgt. Im Grundsatz hat solch ein kaskadierter BAW-Resonator dieselben Impedanzeigenschaften wie ein einzelner entsprechender BAW-Resonator. Die hauptsächliche Motivation für das Kaskadieren ist, wie zuvor erwähnt, die thermische Belastung von BAW-Resonatoren um einen Faktor 4 zu reduzieren, wobei die Reduzierung der thermischen Belastung daraus resultiert, dass ein kaskadiertes Paar von BAW-Resonatoren mit der statischen Kapazität 2C um einen Faktor 4 größer als ein einzelner entsprechender BAW-Resonator mit der statischen Kapazität C ist.

Die US 005231327 A beschreibt beispielsweise einen solchen Ansatz für das Kaskadieren, bei dem ein BAW-Resonator mit der statischen Kapazität C durch eine Serienschaltung von zwei BAW-Resonatoren der statischen Kapazität 2C ersetzt wird, wobei diese zwei BAW-Resonatoren eine gemeinsame Piezo-Schicht aufweisen.

Die US 5294862 A offenbart ein BAW-Filter in Leiterstruktur in dem ein Parallelelement durch zwei antiparallel geschaltete Resonatoren gebildet wird.

Ein weiteres Problem liegt darin, dass bei BAW-Bauelementen beispielsweise BAW-Resonatoren, BAW-Filtern oder BAW-Antennenduplexern, die direkt an der Antenne eines Mobilfunksystems betrieben werden, ein nichtlineares Verhalten zu beobachten ist. Dieses Problem tritt beispielsweise bei BAW-Antennenduplexern auf, wenn die Sendeleistungspegel 0,1 W überschreiten.

Ein Nebeneffekt des oben genannten Kaskadierens ist nun, dass die Energiedichte auch um einen Faktor 4 geringer ist und damit nichtlineare Effekte bei einem kaskadierten Resonator um 6 DB reduziert sind.

Allerdings besteht ein großer Nachteil des Kaskadierens darin, dass das Kaskadieren die Größe des BAW-Bauelements erheblich erhöht, wenn dies für alle BAW-Resonatoren eines Filters gemacht wird. Es ist im allgemeinen unmöglich, das Kaskadieren für alle Resonatorzweige eines Filters zu nutzen, üblicherweise wird das Kaskadieren nur für die kleinsten BAW-Resonatoren im direkten Signalweg angewendet, beispielsweise den Serienresonatoren 48, 50, 52 in einem Filter mit Leiterstruktur gemäß Fig. 4, weil diese BAW-Resonatoren am meisten von dem Risiko des Überhitzens betroffen sind.

Die Aufgabe der vorliegenden Erfindung besteht darin, ein BAW-Filter mit Leiterstruktur anzugeben, in dem BAW-Vorrichtungen verwendet werden, die es ermöglichen, die nichtlinearen Eigenschaften von BAW-Resonatoren zu reduzieren ohne die Abmessungen des BAW-Resonators wesentlich zu vergrößern.

Diese Aufgabe wird durch ein BAW-Filter mit BAW-Vorrichtungen nach Patentanspruch 1 gelöst.

Die vorliegende Erfindung schafft ein BAW-Filter mit BAW-Vorrichtungen mit einem ersten BAW-Resonator und einem zweiten BAW-Resonator, die zueinander antiparallel geschaltet sind.

Der vorliegenden Erfindung liegt die Beobachtung zugrunde, dass die hauptsächlichen Effekte bei dem nichtlinearen Verhalten die Erzeugung einer ausgeprägten zweiten harmonischen Welle bzw. ersten Oberwelle in dem Ausgangsspektrum des BAW-Antennenduplexers sowie Intermodulationseffekte sind. Die Hauptursache für die Nicht-Linearität liegt in der sehr hohen Energiedichte, die bei diesen Leistungspegeln in allen aktiven Schichten des BAW-Bauelements zu finden ist, so dass der Piezoeffekt selbst nicht mehr länger einer rein linearen Beziehung zwischen der Verformung bzw. Beanspruchung (stress) und dem elektrischen Feld folgt.

Der vorliegenden Erfindung liegt weiterhin die Erkenntnis zugrunde, dass sich die Oberwellen der zwei BAW-Resonatoren aufgrund der antiparallelen Verschaltung, d.h. ihrer Parallelschaltung mit zueinander umgekehrter Polarisierung, und der daraus resultierenden Umkehrung des Vorzeichens der angelegten Spannungen bzw. der daraus resultierenden Phasenverschiebungen zwischen den angelegten Spannungen reduzieren und im Idealfall bei entsprechender Dimensionierung auslöschen, so dass nichtlineare Effekte reduziert bzw. ausgelöscht werden.

Genauer ausgedrückt berücksichtigt die vorliegende Erfindung, dass für kleine Spannungen bzw. elektrische Felder eine Verformung des BAW-Resonators proportional zu dem die Verformung erzeugenden elektrischen Feld ist und umgekehrt. Für größere Spannungen bzw. elektrische Felder ist das Verhältnis zwischen dem elektrischen Feld und der dadurch erzeugten Verformung jedoch nicht mehr proportional zueinander, d.h. es wird nichtlinear. Folgende Beobachtungen und Überlegungen führten dies aufgreifend zu der vorliegenden Erfindung.

Zunächst basiert die Erfindung auf der neuartigen Beobachtung, dass der hauptsächliche Mechanismus, der die Abweichung des BAW-Resonators von dem linearen Verhalten verursacht, die Verschiebung der Resonanzfrequenz bei Vorhandensein einer Vorbeanspruchung (bias-stress) bzw. einer zusätzlichen Beanspruchung ist. Diese Vorbeanspruchung kann mechanischer oder elektrischer Natur sein und bewirkt eine Beanspruchungsversteifung (stress stiffening). Diese Beanspruchungsversteifung kann nicht durch lineare Piezo-Gleichungen beschrieben werden.

Die Vorbeanspruchung kann beispielsweise durch mechanischen Druck auf die Piezo-Schicht aber auch durch hohe Spannungen insbesondere durch große Gleichspannungen, die über die Piezo-Schicht angelegt werden, verursacht werden. Es konnte nachgewiesen werden, dass die Resonanzfrequenz sich fast linear auf und ab verändert, während die Gleichspannung in einem weiten Bereich von hohen negativen Spannungen zu hohen positiven Spannungen variert bzw. gewobbelt wird. Dieser Effekt wird VCF-Effekt (VCF = Voltages Coefficient of Frequency, Frequenzspannungskoeffizient) genannt. Dabei ist die Verschiebung der Resonanzfrequenz des BAW-Resonators bezüglich der Richtung der Verschiebung von beispielsweise dem Vorzeichen der Gleichspannung abhängig und bezüglich des Betrags der Verschiebung von dem Betrag der Spannung abhängig. Die Werte für die Frequenzänderung, die für die Aluminiumnitrid basierten BAW-Resonatoren bei 2 Gigahertz gemessen wurden, lagen beispielsweisein in einem Bereich von 20 ppm/V. Für hohe Amplituden von Hochfrequenzsignalen wird diese Belastungsversteifung nun relevant und erzeugt einen starken Anteil bzw. Ton bei dem zweifachen der Frequenz des Erregersignals bzw. Eingangssignals. Hochfrequenzmessungen an dem gleichen, obengenannten BAW-Resonatoren zeigten, dass die reflektierte Leistung eine zweite, harmonische bzw. erste Oberwelle aufwies, die sich bei einer Grundwelle von +30 dBm in einem Bereich von -10 dBm befand.

Basierend auf diesen Ergebnissen wurde ein Simulationsmodell realisiert, das den VCF-Effekt berücksichtigt, mit dem Fazit, dass der VCF-Effekt das nichtlineare Verhalten der BAW-Resonatoren dominiert bzw. maßgeblich beeinflusst und der Schlüssel für eine verbesserte Leistungsfähigkeit ist. Da der VCF-Effekt durch Wechsel des Vorzeichens der angelegten Spannung invertiert werden kann, ist es auch möglich, die Auswirkung des VCF-Effekts auf einen Resonator zu kompensieren, indem derselbe in zwei Bereiche gleicher Größe unterteilt wird und diese zwei Bereiche mit invertierter Phase betrieben werden, in dem nämlich ein BAW-Resonator mit einer statischen Kapazität C in zwei Bereiche unterteilt wird, wobei beide Bereiche eine statische Kapazität von C/2 haben und die zwei Bereiche in antiparalleler Konfiguration betrieben bzw. geschaltet werden, so dass sie sich wie ein BAW-Resonator der statischen Kapazität C verhalten, der jedoch erheblich reduzierte Nicht-Linearität zeigt, weil der VCF-Effekt der zwei Bereiche sich auslöscht. Die Oberschwingungen der erfindungsgemäßen BAW-Vorrichtung bzw. der zwei antiparallel geschalten BAW-Resonatoren überlagern sich, schwächen sich gegenseitig ab und löschen sich bei entsprechender Dimensionierung ganz aus.

Erfindungsgemäß wird ein BAW-Filter mit Leiterstruktur mit BAW-Vorrichtungen geschaffen, die zwei antiparallel geschaltete BAW-Resonatoren aufweisen, und gegenüber entsprechenden, herkömmlichen BAW-Resonatoren verbesserte Eigenschaften, d.h. reduzierte nichtlineare Eigenschaften bzw. reduzierte Oberschwingungen aufweisen.

Erfindungsgemäß können damit Filterschaltungen verbessert werden, indem anstelle von BAW-Resonatoren erfindungsgemäße BAW-Vorrichtungen verwendet werden. Bevorzugte Ausführungsbeispiele der vorliegenden Erfindung weisen zwei BAW-Resonatoren auf, deren Resonanzfrequenz den gleichen Wert hat und die einen gleichen VCF aufweisen, deren Resonanzfrequenz also aufgrund des VCF-Effektes eine Verschiebung in die gleiche Richtung und um den gleichen Betrag erfährt. Durch eine derartige Abstimmung wird gewährleistet, dass die Oberschwingungen der beiden den gleichen Frequenzwert aufweisen.

In einem besonders bevorzugten Ausführungsbeispiel der vorliegenden Erfindung weisen die BAW-Vorrichtungen darüber hinaus zwei BAW-Resonatoren auf, die nicht nur die gleiche Resonanzfrequenz und den gleichen VCF haben, sondern auch die gleiche Impedanz und insbesondere die gleiche statische Kapazität aufweisen, so dass die Amplituden der Oberwellen der antiparallel geschalteten BAW-Resonatoren gleich groß sind und sich somit die ersten Oberschwingungen gegenseitig auslöschen.

Erfindungsgemäße Ausführungsbeispiele haben damit den großen Vorteil, dass sie die Linearität der BAW-Vorrichtung verbessern und die Erzeugung von Oberschwingungen erheblich reduzieren bzw. auslöschen ohne die räumlichen Anforderungen des BAW-Bauelements zu erhöhen.

Im Gegensatz zu der Kaskadierungsmethode erhöht sich erfindungsgemäß der für ein Filter benötigte Gesamtbereich nur geringfügig. Diese Methode ist daher höchst vorteilhaft für Filter in denen die BAW-Resonatorzweige zu groß für eine Kaskadierung sind.

Bevorzugte Ausführungsbeispiele der vorliegenden Erfindung werden nachfolgend bezugnehmend auf die beiliegenden Zeichnungen detailliert erläutert. Es zeigen:
- Fig. 1: einen schematischen Querschnitt einer erfindungsgemäßen BAW-Vorrichtung;
- Fig. 2: ein Blockschaltbild eines BAW-Filters in Leiterstruktur mit drei BAW-Vorrichtungen als Parallelelemente
- Fig. 3: einen schematischen Querschnitt eines BAW-Resonators;
- Fig. 4: Blockschaltbild eines üblichen BAW-Filters in Leiterstuktur.

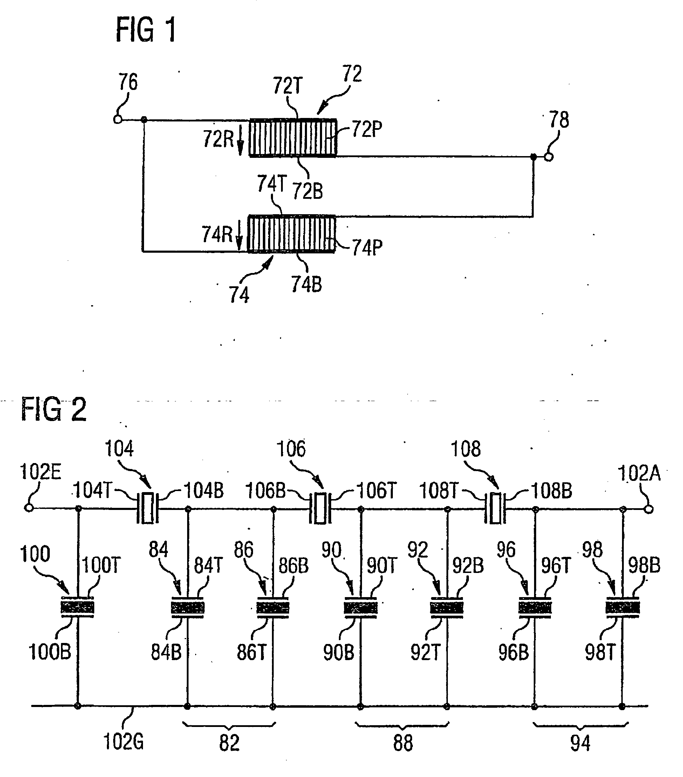

Fig. 1 zeigt einen schematischen Querschnitt eines erfindungsgemäßen Ausführungsbeispiels einer BAW-Vorrichtung mit einem ersten BAW-Resonator 72, der ein Piezo-Schicht 72P, eine erste Elektrode 72T und eine zweite Elektrode 72B aufweist, und einem zweiten BAW-Resonator 74, der eine Piezo-Schicht 74P, eine erste Elektrode 74T und eine zweite Elektrode 74B aufweist. Dabei ist der erste BAW-Resonator 72 von der ersten Elektrode 72T in Richtung der zweiten Elektrode 72B polarisiert und der zweite BAW-Resonator 74 ebenfalls von der ersten Elektrode 74T in Richtung der zweiten Elektrode 74B polarisiert, und die erste Elektrode 72T des ersten BAW-Resonators 72 mit der zweiten Elektrode 74B des zweiten BAW-Resonators 74 und einem ersten elektrischen Anschluss 76 der BAW-Vorrichtung elektrisch verbunden ist, während die zweite Elektrode 72B des ersten BAW-Resonators 72 mit der ersten Elektrode 74T des zweiten BAW-Resonators 74 und einem zweiten elektrischen Anschluss 78 der BAW-Vorrichtung elektrisch verbunden ist. Der Pfeil 72R zeigt eine beispielhafte Richtung einer Polarisation des ersten BAW-Resonators 72 und der Pfeil 74R eine beispielhafte Richtung einer Polarisation des zweiten BAW-Resonators 74. Dabei ist für die erfindungsgemäße BAW-Vorrichtung bzw. antiparallele Schaltung der zwei BAW-Resonatoren 72, 74 nur wesentlich, dass die Polarisationen 72R, 74R der beiden BAW-Resonatoren 72, 74 bezüglich der ersten Elektrode 72T, 74T und der zweiten Elektrode 72B, 74B die gleiche Richtung aufweisen. Alternativ kann beispielsweise die Polarisation beider BAW-Resonatoren 72, 74 auch von der zweiten Elektrode 72B, 74B zu der ersten Elektrode 72T, 74T gerichtet sein.

Die BAW-Vorrichtung besteht also aus einem antiparallel geschalteten BAW-Resonatorpaar.

Der erste BAW-Resonator 72 und der zweite BAW-Resonator 74 weisen dieselbe Kapazität, z.B. C/2 auf, so dass die BAW-Vorrichtung insgesamt als ein BAW-Resonator mit der Kapazität C wirkt, der jedoch gegenüber einem entsprechenden, üblichen BAN-Resonator der Kapazität C wesentlich reduzierte nichtlineare Eigenschaften und damit ein verbessertes Signalübertragungsverhalten bzw. Frequenzverhalten aufweist.

Wie zuvor im Stand der Technik dargestellt, gibt es verschiedenste Ausführungen von BAW-Resonatoren. So können die BAW-Resonatoren 72, 74 alternativ auch mehrere Piezo-Schichten aufweisen, auch wenn Fig. 1 nur eine Piezo-Schicht 72P, 74P zeigt. Darüber hinaus kann die BAW-Vorrichtung durch Zusammenschalten zweier separater bzw. individueller BAW-Resonatoren 72, 74 erfolgen, alternativ beispielsweise aber auch durch zwei BAW-Resonatoren 72, 74 die eine gemeinsame Piezo-Schicht aufweisen. Vorzugsweise werden für eine erfindungsgemäße BAW-Vorrichtung baugleiche BAW-Resonatoren 72, 74 verwendet.

Fig. 2 zeigt ein beispielhaftes Schaltbild eines verbesserten BAW-Filters mit Leiterstruktur mit drei BAW-Vorrichtungen bzw. antiparallelen BAW-Resonatorpaaren als Parallelelemente, wobei eine erste BAW-Vorrichtung 82 aus einem antiparallel geschalteten BAW-Resonatorenpaar 84 und 86, eine zweite BAW-Vorrichtung 88 aus einem antiparallel geschalteten BAW-Resonatorenpaar 90, 92 und eine dritte BAW-Vorrichtung 94 aus einem antiparallel geschalteten BAW-Resonatorenpaar 96 und 98 besteht. Dabei weist der erste BAW-Resonator 84 der ersten BAW-Vorrichtung 82 eine erste Elektrode 84T und eine zweite Elektrode 84B auf, der zweite BAW-Resonator 86 der ersten BAW-Vorrichtung 82 eine erste Elektrode 86T und eine zweite Elektrode 86B auf, der erste BAW-Resonator 90 der zweiten BAW-Vorrichtung 88 eine erste Elektrode 90T und eine zweite Elektrode 90B auf, der zweite BAW-Resonator 92 der zweiten BAW-Vorrichtung 88 eine erste Elektrode 92T und eine zweite Elektrode 92B auf, der erste BAW-Resonator 96 der dritten BAW-Vorrichtung 94 eine erste Elektrode 96T und eine zweite Elektrode 96B auf und der zweite BAW-Resonator 98 der dritten BAW-Vorrichtung 94 eine erste Elektrode 98T und eine zweite Elektrode 98B auf. Als viertes Parallelelement weist Fig. 2 einen üblichen BAW-Resonator 100 auf, der eine erste Elektrode 100T und eine zweite Elektrode 100B aufweist. Des Weiteren weist Fig. 2 in einem Serienpfad zwischen einem Signaleingang 102E und einem Signalausgang 102A drei herkömmliche BAW-Resonatoren auf, wobei ein erster Serien-BAW-Resonator 104 eine erste Elektrode 104T und eine zweite Elektrode 104B aufweist, ein zweiter Serien-BAW-Resonator 106 eine erste Elektrode 106T und eine zweite Elektrode 106B aufweist sowie ein dritte Serien-BAW-Resonator 108 eine erste Elektrode 108T und eine zweite Elektrode 108B aufweist. Sowohl der Signaleingang 102E (IN) als auch der Signalausgang 102A (OUT) sind auf die gemeinsame elektrische Masse 102G (GND) bezogen. Damit zeigt Fig. 2 im Vergleich zu Fig. 4 ein verbessertes BAW-Filter mit Leiterstruktur, bei dem die Parallelresonatoren 56, 58, 60 in Fig. 4 durch die BAW-Vorrichtungen 82, 88, 94 mit vorzugsweise gleicher Kapazität ersetzt wurden. Dabei sind die BAW-Resonatoren der einzelnen BAW-Vorrichtungen erfindungsgemäß antiparallel zueinander geschaltet, beispielsweise ist der erste BAW-Resonator 84 und der zweite BAW-Resonator 86 der ersten BAW-Vorrichtung 82 antiparallel geschaltet, was bildlich durch die Vertauschung der ersten Elektrode 86T des zweiten BAW-Resonators 86 gegenüber der ersten Elektrode 84T des ersten BAW-Resonators 84 bzw. der Vertauschung der zweiten Elektrode 86B des zweiten BAW-Resonators 86 gegenüber der zweiten Elektrode 84B des ersten BAW-Resonators 84 in dem Schaltbild dargestellt wird. Dadurch ist die erste Elektrode 84T, 90T, 96T des ersten Resonators 84, 90, 96 der BAW-Vorrichtungen 82, 88, 94 mit der zweiten Elektrode 86B, 92B, 98B des zweiten BAW-Resonators 86, 92, 98 der BAW-Vorrichtung 82, 88, 94 elektrisch verbunden und umgekehrt.

Ungeachtet des in Fig. 2 beschriebenen Filters weist das erfindungsgemäße BAW-Filter mit Leiterstruktur nur eine BAW Vorrichtung als Parallelelement sondern auch eine BAW-Vorrichtung als Serienelement auf. Natürlich können BAW-Vorrichtungen, so wie für das Parallelelement, überall anstelle der Serien-BAW-Resonatoren 104, 106, 108 eingesetzt werden.

Alternativ können die BAW-Resonatoren 72, 74, 104, 106, 108 auch andere Kapazitäten als C/2 aufweisen.

Ungeachtet der zuvor dargestellten bzw. erläuterten erfindungsgemäßen Ausführungsbeispiele, kann die erfindungsgemäße BAW-Vorrichtung prinzipiell auf alle BAW-Resonatorausführungen angewendet werden, so beispielsweise auch auf BAW-Resonatoren mit mehreren Piezo-Schichten, auf BAW-Resonatoren des Typs FBAR oder SMR, auf BAW-Resonatoren, deren Polarisation nicht parallel zu den Elektroden ausgerichtet ist oder bei denen beide Elektroden auf der gleichen Seite der Piezo-Schicht angeordnet sind.

Erfindungsgemäße Ausführungsbeispiele ermöglichen daher auf effiziente und platzsparende Weise in BAW-Filtern oder BAW-Duplexer anstelle von BAW-Resonatoren BAW-Vorrichtungen so einzusetzen, dass deren Frequenzeigenschaften verbessert werden bzw. deren Nicht-Linearitäten verringert werden.

Darüber hinaus können erfindungsgemäße BAW-Vorrichtungen nicht nur zwei BAW-Resonatoren sondern auch mehrere BAW-Resonatoren aufweisen, die antiparallel geschaltet sind. Zusammenfassend kann daher gesagt werden, dass erfindungsgemäße BAW-Vorrichtungen es ermöglichen, nichtlineare Effekte in BAW-Filtern zu reduzieren bzw. auszulöschen, in dem antiparallel geschaltete Resonatorenpaare oder Resonatorengruppen in diesen Filtern eingesetzt werden. Diese antiparallel geschalteten Resonatorenpaare oder Resonatorengruppen ermöglichen eine erhebliche Reduzierung der nichtlineare Effekte bzw. verringern die Erzeugung von harmonischen bzw. Oberschwingungen erheblich ohne jedoch die Abmessungen der BAW-Bauelemente im Filter oder die Kosten für die BAW-Bauelemente im Filter zu erhöhen.

### Bezugszeichenliste

- 30: BAW-Resonator
- 32: Piezo-Schicht
- T: erste bzw. Top-Elektrode
- B: zweite bzw. Bottom-Elektrode
- 42: elektrische Masse
- 44: Signaleingang
- 46: Signalausgang
- 48: erster Serienresonator
- 50: zweiter Serienresonator
- 52: dritter Serienresonator
- 54: erster Parallelresonator
- 56: zweiter Parallelresonator
- 58: dritter Parallelresonator
- 60: vierter Parallelresonator
- 72: erster BAW-Resonator
- 72P: Piezo-Schicht des ersten BAW-Resonators
- 72T: erste Elektrode des ersten BAW-Resonators
- 72B: zweite Elektrode des ersten BAW-Resonators
- 74: zweiter BAW-Resonator
- 74P: Piezo-Schicht des zweiten BAW-Resonators
- 74T: erste Elektrode des zweiten BAW-Resonators
- 74B: zweite Elektrode des zweiten BAW-Resonators
- 76: erster elektrischer Anschluss der BAW-Vorrichtung
- 78: zweiter elektrischer Anschluss der BAW-Vorrichtung
- 82: erste BAW-Vorrichtung
- 84: erste BAW-Resonator der ersten BAW-Vorrichtung
- 84T: erste Elektrode des ersten BAW-Resonators der ersten BAW-Vorrichtung
- 84B: zweite Elektrode des ersten BAW-Resonators der ersten BAW-Vorrichtung
- 86: zweiter BAW-Resonator der ersten BAW-Vorrichtung
- 86T: erste Elektrode des zweiten BAW-Resonators der ersten BAW-Vorrichtung
- 86B: zweite Elektrode des zweiten BAW-Resonators der ersten BAW-Vorrichtung

- 88: zweite BAW-Vorrichtung
- 90: erster BAW-Resonator der zweiten BAW-Vorrichtung
- 90T: erste Elektrode des ersten BAW-Resonators der zweiten BAW-Vorrichtung
- 90B: zweite Elektrode des ersten BAW-Resonators der zweiten BAW-Vorrichtung
- 92: zweiter BAW-Resonator der zweiten BAW-Vorrichtung
- 92T: erste Elektrode des zweiten BAW-Resonators der zweiten BAW-Vorrichtung
- 92B: zweite Elektrode des zweiten BAW-Resonators der zweiten BAV-Vorrichtung
- 94: dritte BAW-Vorrichtung
- 96: erste BAW-Resonator der dritten BAW-Vorrichtung
- 96T: erste Elektrode des ersten BAW-Resonators der dritten BAW-Vorrichtung
- 96B: zweite Elektrode des ersten BAW-Resonators der dritten BAW-Vorrichtung
- 98: zweite BAW-Resonator der dritten BAW-Vorrichtung
- 98T: erste Elektrode des zweiten BAW-Resonators der dritten BAW-Vorrichtung
- 98B: zweite Elektrode des zweiten BAW-Resonators der dritten BAW-Vorrichtung
- 100: üblicher BAW-Resonator
- 100T: erste Elektrode des üblichen BAW-Resonators
- 100B: zweite Elektrode des üblichen BAW-Resonators
- 102E: Signaleingang
- 102A: Signalausgang
- 102G: elektrische Masse

## Patentansprüche

1. BAW-Filter mit Leiterstruktur, das
einen Signaleingang (102E) und einen Signalausgang (102A), die auf eine gemeinsame Masse (102G) bezogen sind,
eine erste BAW-Vorrichtung und
eine zweite BAW-Vorrichtung (82)
aufweist,
wobei ein Serienpfad zwischen dem Signaleingang (102E) und dem Signalausgang (102A) gebildet ist,
wobei die erste BAW-Vorrichtung in dem Serienpfad eingesetzt ist und die zweite BAW-Vorrichtung (82) als Parallelelement mit der gemeinsamen Masse (102G) verbunden ist,
wobei die erste BAW-Vorrichtung und die zweite BAW-Vorrichtung jeweils einen ersten BAW-Resonator (72, 84, 90, 96) und einen zweiten BAW-Resonator (74, 86, 92, 98) aufweisen,
wobei in beiden BAW-Vorrichtungen der erste BAW-Resonator (72, 84, 90, 96) eine dem ersten BAW-Resonator (72, 84, 90, 96) zugeordnete Piezo-Schicht (72P) aufweist,
wobei in beiden BAW-Vorrichtungen der zweite BAW-Resonator (74, 86, 92, 98) eine dem zweiten BAW-Resonator (74, 86, 92, 98) zugeordnete Piezo-Schicht (74P) aufweist,
wobei in beiden BAW-Vorrichtungen die erste Elektrode (72T) des ersten BAW-Resonators (72) mit der zweiten Elektrode (74B) des zweiten BAW-Resonators (74) und einem ersten elektrischen Anschluss (76) der jeweiligen BAW-Vorrichtung elektrisch verbunden ist und die zweite Elektrode (72B) des ersten BAW-Resonators (72) mit der ersten Elektrode (74T) des zweiten BAW-Resonators (74) und einem zweiten elektrischen Anschluss (78) der jeweiligen BAW-Vorrichtung elektrisch verbunden ist und ferner die BAW-Resonatoren (72, 74) bzgl. ihrer ersten Elektrode (72T, 74T) und ihrer zweiten Elektrode (72B, 74B) die gleiche Polarisation aufweisen.

2. BAW-Filter nach Anspruch 1, bei dem in beiden BAW-Vorrichtungen eine Resonanzfrequenz des ersten BAW-Resonators (72, 84, 90, 96) und eine Resonanzfrequenz des zweiten BAW-Resonators (74, 86, 92, 98) den gleichen Wert aufweisen.

3. BAW-Filter nach Anspruch 2, bei dem in beiden BAW-Vorrichtungen die Resonanzfrequenz des ersten BAW-Resonators (72, 84, 90, 96) und die Resonanzfrequenz des zweiten BAW-Resonators (74, 86, 92, 98) eine gleiche Verschiebung in Betrag und Richtung der Resonanzfrequenz aufgrund eines VCF-Effektes (VCF = Voltage Coefficient of Frequency) aufweisen.

4. BAW-Filter nach einem der Ansprüche 1 bis 3, bei dem in beiden BAW-Vorrichtungen eine Impedanz des ersten BAW-Resonators (72, 84, 90, 96) und eine Impedanz des zweiten BAW-Resonators (74, 86, 92, 98) gleich sind.

5. BAW-Filter nach einem der Ansprüche 1 bis 4, bei dem in beiden BAW-Vorrichtungen eine Kapazität des ersten BAW-Resonators (72, 84, 90, 96) und eine Kapazität des zweiten BAW-Resonators (74, 86, 92, 98) gleich sind und einen Wert C/2 aufweisen und somit die jeweilige BAW-Vorrichtung eine Gesamtkapazität C aufweist.

6. BAW-Filter nach einem der Ansprüche 1 bis 5, bei dem in beiden BAW-Vorrichtungen der erste BAW-Resonator (72, 84, 90, 96) und der zweite BAW-Resonator (74, 86, 92, 98) baugleich sind.

7. Duplexer, der einen BAW-Filter nach einem der Ansprüche 1 bis 6 aufweist.

8. BAW-Filter nach einem der Ansprüche 1 bis 6,
wobei in beiden BAW-Vorrichtungen eine Polarisationsrichtung des ersten BAW-Resonators und des zweiten BAW-Resonators nicht parallel zu Elektroden des ersten bzw. zweiten BAW-Resonators ausgerichtet ist.

## Claims

1. A BAW filter having a ladder structure, comprising
a signal input (102 E) and a signal output (102 A) which are related to a common ground,
a first BAW device and
a second BAW device (82),
wherein a serial path is formed between the signal input (102 E) and the signal output (102 A),
wherein the first BAW device is inserted into the serial path and the second BAW device (82) is connected to the common ground (102 G) as a parallel element,
wherein the first BAW device and the second BAW device comprise each a first BAW resonator (72, 84, 90, 96) and a second BAW resonator (74, 86, 92, 98),
wherein, in both BAW devices, the first BAW resonator (72, 84, 90, 96) comprises a piezo layer (72 P) assigned to the first BAW resonator (72, 84, 90, 96),
wherein, in both BAW devices, the second BAW resonator (74, 86, 92, 98) comprises a piezo layer (74 P) assigned to the second BAW resonator (74, 86, 92, 98),
wherein, in both BAW devices, the first electrode (72 T) of the first BAW resonator (72) is electrically connected to the second electrode (74 B) of the second BAW resonator (74) and a first electrical terminal (76) of the respective BAW device and the second electrode (72 B) of the first BAW resonator (72) is electrically connected to the first electrode (74 T) of the second BAW resonator (74) and a second electrical terminal (78) of the respective BAW device and the BAW resonators (72, 74) further have the same polarization with regard to their first electrode (72 T, 74 T) and their second electrode (72 B, 74 B).

2. The BAW filter according to claim 1, wherein, in both BAW devices, a resonance frequency of the first BAW resonator (72, 84, 90, 96) and a resonance frequency of the second BAW resonator (74, 86, 92, 98) have the same value.

3. The BAW filter according to claim 2, wherein, in both BAW devices, the resonance frequency of the first BAW resonator (72, 84, 90, 96) and the resonance frequency of the second BAW resonator (74, 86, 92, 98) have an equal displacement of the resonance frequency in magnitude and direction due to a VCF effect (VCF = voltage coefficient of frequency).

4. The BAW filter according to any one of the claims 1 to 3, wherein, in both BAW devices, an impedance of the first BAW resonator (72, 84, 90, 96) and an impedance of the second BAW resonator (74, 86, 92, 98) are equal.

5. The BAW filter according to any one of the claims 1 to 4, wherein, in both BAW devices, a capacitance of the first BAW resonator (72, 84, 90, 96) and a capacitance of the second BAW resonator (74, 86, 92, 98) are equal and have a value of C/2 and thus the respective BAW device has an overall capacitance of C.

6. The BAW filter according to any one of the claims 1 to 5, wherein, in both BAW devices, the first BAW resonator (72, 84, 90, 96) and the second BAW resonator (74, 86, 92, 98) are identical in construction.

7. A Duplexer comprising a BAW filter according to any one of the claims 1 to 6.

8. A BAW filter according to any one of the claims 1 to 6,
wherein, in both BAW devices, a polarization direction of the first BAW resonator and of the second BAW resonator is not parallel aligned to electrodes of the first and second BAW resonator, respectively.

## Revendications

1. Filtre BAW (à ondes acoustiques de volume) comportant une structure conductrice qui comprend
une entrée (102E) de signal et une sortie (102A) de signal, qui se rapportent à une masse commune (102G),
un premier dispositif BAW et
un deuxième dispositif BAW (82),
dans lequel un circuit en série est prévu entre l'entrée (102E) de signal et la sortie (102A) de signal,
dans lequel le premier dispositif BAW du circuit en série est utilisé et le deuxième dispositif BAW (82) est relié à la masse commune (102G) en tant qu'élément parallèle,
dans lequel le premier dispositif BAW et le deuxième dispositif BAW comprennent chacun un premier résonateur BAW (72, 84, 90, 96) et un deuxième résonateur BAW (74, 86, 92, 98),
dans lequel le premier résonateur BAW (72, 84, 90, 96) comprend, dans les deux dispositifs BAW, une couche piézo (72P) associée au premier résonateur BAW (72, 84, 90, 96),
dans lequel le deuxième résonateur BAW (74, 86, 92, 98) comprend, dans les deux dispositifs BAW, une couche piézo (74P) associée au deuxième résonateur BAW (74, 86, 92, 98),
dans lequel, dans les deux dispositifs BAW, la première électrode (72T) du premier résonateur BAW (72) est reliée électriquement à la deuxième électrode (74B) du deuxième résonateur BAW (74) et à un premier raccordement électrique (76) du dispositif BAW respectif et la deuxième électrode (72B) du premier résonateur BAW (72) est reliée électriquement à la première électrode (74T) du deuxième résonateur BAW (74) et à un deuxième raccordement électrique (78) du dispositif BAW respectif et, de plus, les résonateurs BAW (72, 74) possèdent la même polarisation au niveau de leur première électrode (72T, 74T) et leur deuxième électrode (72B, 74B).

2. Filtre BAW selon la revendication 1 dans lequel une fréquence de résonance du premier résonateur BAW (72, 84, 90, 96) et une fréquence de résonance du deuxième résonateur BAW (74, 86, 92, 98) possèdent, dans les deux dispositifs BAW, une valeur identique.

3. Filtre BAW selon la revendication 2 dans lequel la fréquence de résonance du premier résonateur BAW (72, 84, 90, 96) et la fréquence de résonance du deuxième résonateur BAW (74, 86, 92, 98) possèdent, dans les deux dispositifs BAW, un décalage identique en étendue et en direction de la fréquence de résonance en raison d'un effet VCF (VCF = Voltage Coefficient of Frequency).

4. Filtre BAW selon l'une des revendications 1 à 3 dans lequel une impédance du premier résonateur BAW (72, 84, 90, 96) et une impédance du deuxième résonateur BAW (74, 86, 92, 98) sont identiques, dans les deux dispositifs BAW.

5. Filtre BAW selon l'une des revendications 1 à 4 dans lequel, dans les deux dispositifs BAW, une capacité du premier résonateur BAW (72, 84, 90, 96) et une capacité du deuxième résonateur BAW (74, 86, 92, 98) sont identiques et possèdent une valeur C/2, et chaque dispositif BAW possède ainsi une capacité totale C.

6. Filtre BAW selon l'une des revendications 1 à 5 dans lequel le premier résonateur BAW (72, 84, 90, 96) et le deuxième résonateur BAW (74, 86, 92, 98) sont de construction identique, dans les deux dispositifs BAW.

7. Duplexeur comprenant un filtre BAW selon l'une des revendications 1 à 6.

8. Filtre BAW selon l'une des revendications 1 à 6, dans lequel une direction de polarisation du premier résonateur BAW et du deuxième résonateur BAW n'est pas orientée parallèlement aux électrodes du premier ou du deuxième résonateur BAW.
